# EUROPEAN PATENT APPLICATION

(11) **EP 1 357 600 A2**
(43) Date of publication of application: **29.10.2003**
(21) Application number: 03252479.5
(22) Date of filing: 17.04.2003
(51) Int. Cl.: H01L 27/08, H01L 21/02

(54) **Solid-state inductor and method for producing the same**

(30) Priority: 22.04.2002 US 131411
(71) Applicant: Sharp Kabushiki Kaisha, Osaka-shi, Osaka 545-8522 (JP)
(72) Inventor: Pan, Wei, Vancouver, WA 98683 (US); Hsu, Sheng Teng, Camas, WA 98607 (US); Zhuang, Wei Wei, Vancouver, WA 98683 (US)
(74) Representative: Brown, Kenneth Richard

(57) **Abstract**

A method for producing a solid-state inductor according to the present invention is a method for producing a solid-state inductor, comprising: forming a bottom electrode; forming a colossal magnetoresistance (CMR) thin film overlying the bottom electrode; forming a top electrode overlying the CMR thin film; and applying an electrical field treatment to the CMR thin film and, in response to the electrical field treatment, converting the CMR thin film into a CMR thin film inductor.

## Description

### 1. FIELD OF THE INVENTION:

This invention relates to a solid-state inductor and a method for producing the same and, more particularly, to an inductor such as a solid-state inductor for analog integrated circuit (IC) and a method for producing the same.

### 2. DESCRIPTION OF THE RELATED ART:

A conventional solid-state inductor (a solid-state inductor which is IC integrated is called an IC integrated inductor) is formed from a metal line, designed in spiral form, overlying a thick layer of insulator on silicon substrate. The inductance value of an inductor so formed is very low, so that the formation of a practical inductor requires a large silicon area. Besides using a great amount of valuable IC area, the large-sized inductors generate parasitic reactances and unintended mutual inductances with components that are adjacent, overlying, or underlying the inductor.

Further, the IC integrated inductor is a passive component, meaning that once it is formed in the IC, the inductance value cannot be changed. Thus, the inductor cannot be used for frequency tuning. An inductor for frequency tuning would be desirable in the fabrication of circuits such as filters, antennas, and oscillators, to name a few of examples.

In the prior art as described above, it was difficult to implement an inductor having a large inductance value to reduce the size thereof. Further, it is not possible to use an inductor for frequency tuning by varying the inductance value of the IC integrated inductor.

### SUMMARY OF THE INVENTION

According to one aspect of the present invention, there is provided a method for producing a solid-state inductor, the method comprising: forming a bottom electrode; forming a colossal magnetoresistance (CMR) thin film overlying the bottom electrode; forming a top electrode overlying the CMR thin film; and applying an electrical field treatment to the CMR thin film and, in response to the electrical field treatment, converting the CMR thin film into a CMR thin film inductor.

In one embodiment of the invention, a method for producing a solid-state inductor further comprises applying a bias voltage between the top and bottom electrodes, and, in response to the applied bias voltage, creating an inductance between the top and bottom electrodes.

In one embodiment of the invention, a method for producing a solid-state inductor further comprises: varying the applied bias voltage; and varying the inductance in response to variances in the applied bias voltage.

In one embodiment of the invention, forming a colossal magnetoresistance (CMR) thin film overlying the bottom electrode includes using a material selected from the group including Pr_{0.3}Ca_{0.7}MnO₃ (PCMO), La_{0.7}Ca_{0.3}MnO₃ (LCMO), Y₁₋ₓCaₓMnO₃ (YCMO), and high-temperature super conductor (HTSC) materials as a colossal magnetoresistance (CMR) thin film material.

In one embodiment of the invention, forming a colossal magnetoresistance (CMR) thin film overlying the bottom electrode includes forming a colossal magnetoresistance (CMR) thin film having a thickness of approximately 2000 Å.

In one embodiment of the invention, forming a colossal magnetoresistance (CMR) thin film overlying the bottom electrode includes: spin-coating a first layer having a thickness of approximately 670 Å; annealing the first layer at a temperature of approximately 650 degrees C for a period of approximately 30 minutes; spin-coating a second layer, having a thickness of approximately 670 Å, overlying the first layer; annealing the second layer at a temperature of approximately 550 degrees C for a period of approximately 30 minutes; spin-coating a third layer, having a thickness of approximately 670 Å, overlying the second layer; and annealing the third layer at a temperature of approximately 550 degrees C for a period of approximately 30 minutes.

In one embodiment of the invention, wherein forming a bottom electrode includes forming a bottom electrode from a material selected from the group including Al, Au, Ti, Ta, Pt, Cu, W, Ir, AlSi, and other noble metals.

In one embodiment of the invention, forming a top electrode includes forming a top electrode from a material selected from the group including Al, Au, Ti, Ta, Pt, Cu, W, Ir, AlSi, and other noble metals.

In one embodiment of the invention, applying an electrical field treatment to the CMR thin film includes applying an electric field in the range of 0.4 to 1 megavolts per centimeter (MV/cm) with a pulse width in the range of 100 nanoseconds (ns) to 1 millisecond (ms).

In one embodiment of the invention, applying a bias voltage between the top and bottom electrodes includes applying a bias voltage selected from the group including: a dc voltage within the range of 0.5 to 5 volts; and a dc voltage within the range of -0.5 to -5 volts.

In one embodiment of the invention, creating an inductance between the top and bottom electrodes includes creating an inductance in the range of greater than 0.01 micro-Henry (µH) to less than 1 µH.

In one embodiment of the invention, varying the inductance between the top and bottom electrodes in response to variances in the applied bias voltage includes creating the maximum inductance at a bias voltage selected from the group including +1 dc volt and -1 dc volt.

In one embodiment of the invention, applying an electrical field treatment to the CMR thin film includes applying an electric field while simultaneously annealing the CMR thin film.

According to another aspect of this invention, there is provided a method for producing a solid-state inductor, the method comprising: forming a bottom electrode; forming a colossal magnetoresistance (CMR) thin film overlying the bottom electrode; forming a top electrode overlying the CMR thin film; applying an electrical field treatment to the CMR thin film in the range of 0.4 to 1 megavolts per centimeter (MV/cm) with a pulse width in the range of 100 nanoseconds (ns) to 1 millisecond (ms) and, in response to the electrical field treatment, converting the CMR thin film into a CMR thin film inductor; applying a bias voltage between the top and bottom electrodes; in response to the applied bias voltage, creating an inductance between the top and bottom electrodes; and varying the applied bias voltage and varying the inductance in response to varying the bias voltage.

According to still another aspect of this invention, there is provided a solid-state inductor, the inductor comprising: a bottom electrode; an electric field-treated colossal magnetoresistance (CMR) thin film overlying the bottom electrode; and a top electrode overlying the CMR thin film.

In one embodiment of the invention, a solid-state inductor further comprises: a means for applying a bias voltage between the top and bottom electrodes; and wherein an inductance is created between the top and bottom electrodes in response to the applied bias voltage.

In one embodiment of the invention, the voltage applying means varies the applied bias voltage; and the inductance between the top and bottom electrodes varies in response to variances in the applied bias voltage.

In one embodiment of the invention, the colossal magnetoresistance (CMR) thin film includes a Pr_{0.3}Ca_{0.7}MnO₃ (PCMO), La_{0.7}Ca_{0.3}MnO₃ (LCMO), Y₁₋ₓCaₓMnO₃ (YCMO), and high-temperature super conductor (HTSC) materials.

In one embodiment of the invention, the colossal magnetoresistance (CMR) thin film has a thickness of approximately 2000 Å.

In one embodiment of the invention, the bottom electrode includes a material selected from the group including Al, Au, Ti, Ta, Pt, Cu, W, Ir, AlSi, and other noble metals.

In one embodiment of the invention, the top electrode is formed of a material selected from the group including Al, Au, Ti, Ta, Pt, Cu, W, Ir, AlSi, and other noble metals.

In one embodiment of the invention, the electric field-treated CMR thin film has been exposed to an electric field in the range of 0.4 to 1 MV/cm, with a pulse width in the range of 100 nanoseconds (ns) to 1 millisecond (ms).

In one embodiment of the invention, the bias applying means applies a bias voltage between the top and bottom electrodes selected from the group including: a dc voltage within the range of 0.5 to 5 volts; and a dc voltage within the range of -0.5 to -5 volts.

In one embodiment of the invention, the inductance between the top and bottom electrodes has a value in the range of greater than 0.01 micro-Henrys (µH) to less than 1 µH.

In one embodiment of the invention, the inductance between the top and bottom electrodes is a maximum value in response to an applied bias voltage selected from the group including +1 dc volt and -1 dc volt.

With the above-described structure, it is possible to provide a solid-state inductor, which has a relatively high inductance value, requiring a very small chip area, and is suitable to be integrated into the conventional integrated circuits (it can be a CMOS or a Bipolar circuit fabricated on silicon, or on compound semiconductor substrate) and a production method thereof. Furthermore, since an inductance value can be varied in the IC circuit, tuning can be performed more easily.

Thus, the invention described herein makes possible the advantages of (1) providing a solid-state inductor having a large inductance value to reduce the size thereof and a method for producing the same, and (2) providing a solid-state inductor which can be easily used for tuning by varying an inductance value in the IC circuit and the method for producing the same.

These and other advantages of the present invention will become apparent to those skilled in the art upon reading and understanding the following detailed description with reference to the accompanying figures.

### BRIEF DESCRIPTION OF THE DRAWINGS

Figure **1** is a schematic view showing a general structure of an inductor according to the present invention.
Figure **2** is a cross-sectional view of a device structure where two of the inductors according to the present invention are applied to an actual IC integrated circuit.
Figure **3** illustrates the reactance of an exemplary CMR thin film, before electric field treatment.
Figure **4** illustrates the reactance of the exemplary CMR thin film after electric field treatment.
Figure **5** is a flowchart illustrating an embodiment of a production method of a solid-state inductor according to the present invention.

### DESCRIPTION OF THE PREFERRED EMBODIMENTS

Now, a solid-state inductor of the present invention (hereinafter, simply referred to as an inductor) and a method for producing the same will be described with reference to the drawings.

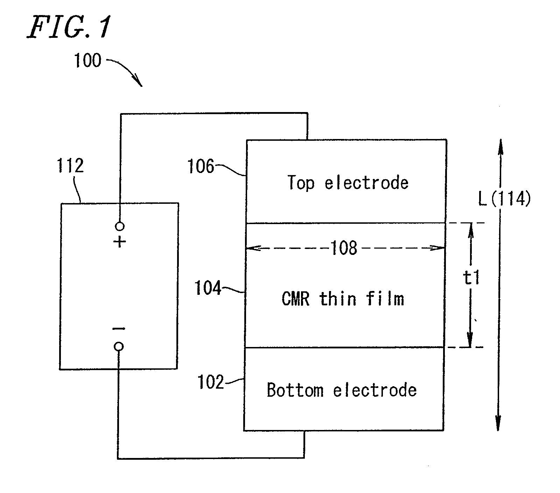

Figure **1** is a schematic view showing a general structure of the inductor according to the present invention.

In Figure **1**, the inductor **100** comprises a bottom electrode **102**, an electric field-treated colossal magnetoresistance (CMR) thin film **104** overlying the bottom electrode **102,** and a top electrode **106** overlying the CMR thin film **104**.

The CMR thin film **104** is made from a material such as Pr_{0.3}Ca_{0.7}MnO₃ (PCMO), La_{0.7}Ca_{0.3}MnO₃ (LCMO), Y₁₋ₓCaₓMnO₃ (YCMO), or high-temperature super conductor (HTSC) materials. However, other equivalent materials might also be practical, depending upon requirements. The CMR thin film **104** has a thickness **t1** of approximately 2000 Å.

As explained in more detail now, the CMR thin film **104** is exposed to an electric field in the range of 0.4 to 1 megavolts per centimeter (MV/cm), with a pulse width in the range of **100** nanoseconds (ns) to 1 millisecond (ms). This is just an exemplary treatment. Other means of treatment are practical and depend upon the CMR material, intervening materials, and the desired inductance.

The bottom electrode **102** of the inductor **100** is made from a material selected from the group including Al, Au, Ti, Ta, Pt, Cu, W, Ir, AlSi, or other noble metals. However, other conductor materials, well known in the fabrication of ICs could also be used. Likewise, the top electrode **106** is typically made from a material selected from the group including Al, Au, Ti, Ta, Pt, Cu, W, Ir, AlSi, or other noble metals.

A voltage applying means **112** for applying a bias voltage between the top electrode **106** and the bottom electrode **102** of the inductor **100** is provided. Typically, the inductor **100** includes a part of a larger, more complex circuit, and the bias voltage and relative ground zero potential are connected through other components, such as transistors, not shown. An inductance, or inductance value L **(114)** of the inductor **100** is created at the CMR thin film **104** between the top and bottom electrodes **106/102** in response to the applied bias voltage from the voltage applying means **112.**

In some aspects, the voltage applying means **112** may vary the bias voltage to be applied to the inductor **100**. The inductance value L **(114)** between the top and bottom electrodes **106/102** varies in response to variances in the applied bias voltage. Some practical bias voltage ranges have been developed as an example. In some aspects, the voltage applying means **112** applies a voltage between the top and bottom electrodes **106/102** within the range of either 0.5 to 5 dc volts, or - 0.5 to -5 do volts. However, for specific circuit applications an ac voltage can also be used. Further, other dc voltage ranges can be used for different variations of CMR material, CMR volume, and the electric field treatments.

Using the above-mentioned bias voltage values, the inductance **114** between the top and bottom electrodes **106/102** can be in the range of greater than 0.01 micro-Henrys (µH) to less than 1 µH, depending on bias voltage, the CMR material, and the geometries (volume, diameter **108**, and thickness t1) of the CMR thin film **104**. Typically, the inductance value L (114) between the top and bottom electrodes **106/102** is a maximum value in response to an applied voltage of either +1 dc volt or -1 dc volt. Again however, the relationship between maximum inductance and bias voltage is dependent upon CMR material and CMR geometries.

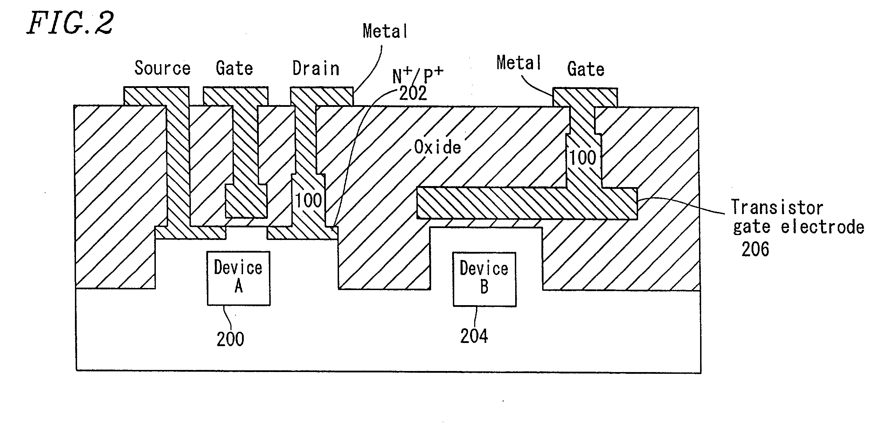

Figure **2** is a cross-sectional view of a device structure where two of the inductors **100** according to the present invention are applied to an actual IC integrated circuit.

As shown in Figure **2**, the inductor **100** according to the present invention is a two terminal pillar structure. The inductor **100** can be fabricated into a single via hole with bottom electrode onto a pn junction, or on a local interconnect metal line. The inductor **100** can be integrated to the IC after the completion of the front end of processing. In device A **200**, the inductor **100** is integrated to a drain junction **202**. In device B **204**, another inductor **100** is integrated to a gate electrode **206.** The inductor(s) **100** can be deposited onto the semiconductor substrate using conventional deposition methods, such as spin coating, sputtering and CVD process. Further, the inductor **100** has very high inductance that, using a bias voltage control, can vary more than two orders of magnitudes. The tuning of any LC circuit, of which the inductor **100** is a part, can be achieved by adjusting the bias voltage across the inductor **100**.

For example, the inductor **100** according to the present invention can be made using a colossal magnetoresistance (CMR) thin film resistor, fabricated using a spin-coating process. The CMR material can be PCMO (Pr_{0.3}Ca_{0.7}MnO₃). The CMR thin film is coated three times for a total thickness of about **200** nm onto Platinum substrate. The CMR thin film is annealed at 650°C for 30 minutes after a first coating, and annealed at 550°C for 30 minutes after the second and the third coatings. The top electrode **106** is also Platinum, although some other metals such as Al, Cu, W, Ir, AlSi, or other noble metals may also be used. The impedance of the CMR thin film **104** immediately after fabrication or as-fabricated is measured having resistance R due to a resistance component and capacitance C due to a capacitance component.

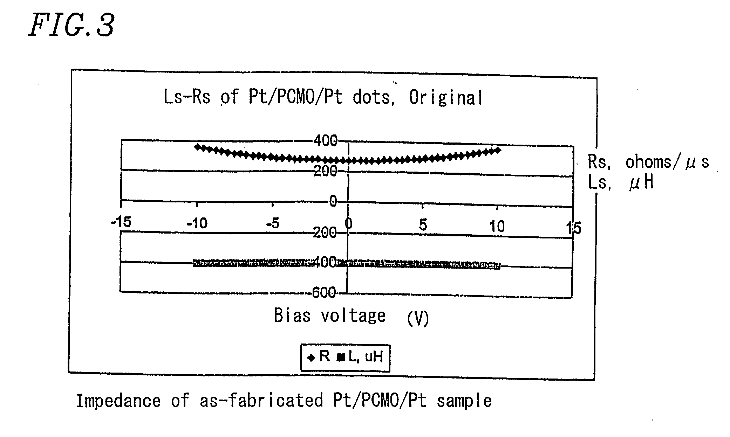

Figure **3** illustrates the reactance of an exemplary CMR thin film, before electric field treatment.

All measurements shown in Figure **3** are of resistance in series with inductance value. The measurement frequency is 1MHz. The measured inductance shown is negative and, therefore, capacitive.

Figure **3** also shows that the capacitance value and the resistance value of this CMR thin film is practically independent of the bias voltage value in the given measurement region.

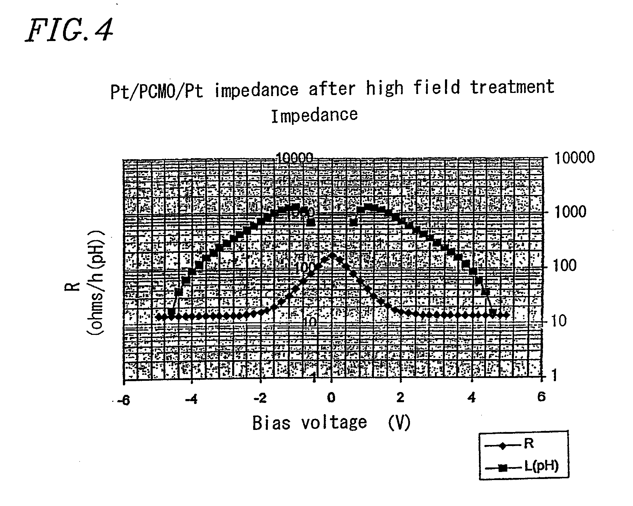

Figure **4** illustrates the reactance of the exemplary CMR thin film after electric field treatment.

As shown in Figure **4**, the property of the impedance changes drastically after an electric field of 0.4 MV/cm to 1MV/cm is applied to the CMR thin film **104** via the top electrode **106** and the bottom electrode **102.** The resistance of the CMR thin film **104** decreases from about 275 Ohms to lower than 20 Ohm. The CMR thin film **104** becomes inductive in response to bias voltages of -5V to -0.5V, or 0.5V to 5V. Outside of these bias voltage ranges, the reactance of the CMR thin film **104** is capacitance. The maximum inductance is more than 1 µH.

The inductance value of the PCMO solid-state inductor **100** can be varied by more than two orders of magnitude by changing the bias voltage applied to the device. From the nature of the material, it is expected that colossal magnetoresistance (CMR) and high temperature super conductor (HTSC) material are practical for electrically tunable solid-state inductor fabrication. The device area determines the magnitude of the inductance. The electrically tunable inductor **100** is suitable as a build-in element for filters and antennas of any integrated circuit.

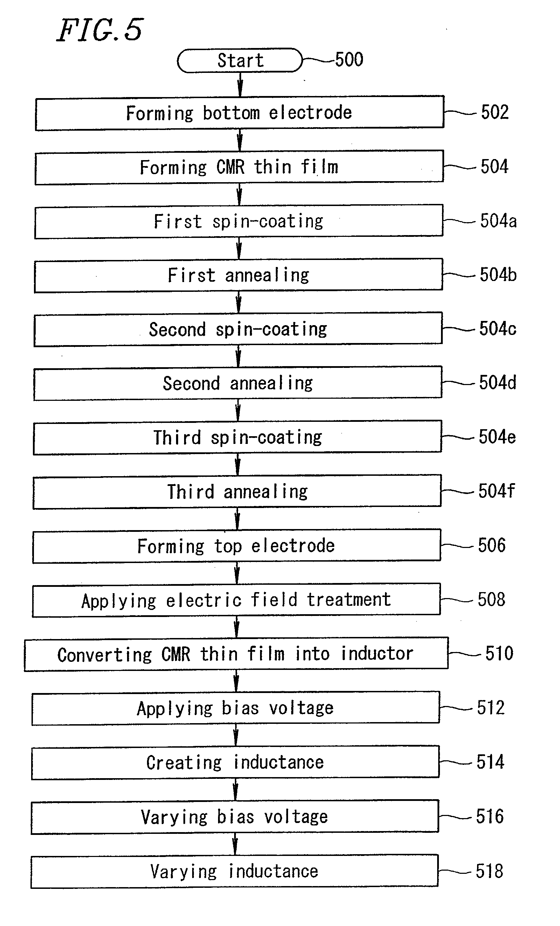

Figure **5** is a flowchart illustrating an embodiment of a production method of a solid-state inductor **100** according to the present invention.

As shown in Figure **5**, although the production method of the inductor **100** is depicted as a sequence of numbered steps for clarity in description, no order should be inferred from the numbering unless explicitly stated. It should be understood that some of these steps may be skipped, performed in parallel, or performed without the requirement of maintaining a strict order of sequence.

As shown in Figure **5**, the production of the solid-state inductor **100** starts at Step 500.

Step 502 forms a bottom electrode **102.**

Step 504 forms a colossal magnetoresistance (CMR) thin film 104 overlying the bottom electrode **102**.

Step 506 forms a top electrode **106** overlying the CMR thin film **104**.

Step 508 applies an electrical field treatment to the CMR thin film **104**. Alternately, Step 508 applies an electric field while simultaneously annealing the CMR thin film **104**.

Step 510, in response to the electrical field treatment, converts the CMR thin film **104** into a CMR thin film inductor **100**.

Now, the above production method of the inductor **100** will be described in more detail. Some aspects include further steps. Step 512 which follows step 510 applies a bias voltage between the top and bottom electrodes.

Step 514, in response to the applied bias voltage, creates an inductance between the top electrode **106** and the bottom electrode **102.**

In other aspects, Step 516 varies the applied bias voltage.

Step 518 varies the inductance in response to variances in the applied bias voltage.

Then, returned to step 504, forming a CMR thin film **104** overlying the bottom electrode **102** includes using a material such as Pr_{0.3}Ca_{0.7}MnO₃ (PCMO), La_{0.7}Ca_{0.3}MnO₃ (LCMO), Y₁₋ₓCaₓMnO₃ (YCMO), or high-temperature super conductor (HTSC) materials. In some aspects, the CMR thin film **104** is formed to thickness of approximately 2000 Å, depending upon the variables mentioned above.

In some aspects, forming a CMR thin film overlying the bottom electrode **102** in Step 504 includes substeps 504a to 504f.

First, Step 504a spin-coats a first layer having a thickness of approximately 670 Å.

Next, Step 504b anneals the first layer at a temperature of approximately 650 degrees C for a period of approximately 30 minutes.

Then, Step 504c spin-coats a second layer, having a thickness of approximately 670 Å, overlying the first layer.

Then, Step 504d anneals the second layer at a temperature of approximately 550 degrees C for a period of approximately 30 minutes.

Then, Step 504e spin-coats a third layer, having a thickness of approximately 670 Å, overlying the second layer.

Lastly, Step 504f anneals the third layer at a temperature of approximately 550 degrees C for a period of approximately 30 minutes.

In some aspects of the method, forming a bottom electrode **102** in Step 502 includes forming a bottom electrode **102** from a material such as Al, Au, Ti, Ta, Pt, Cu, W, Ir, AlSi, or other noble metals. Likewise, forming a top electrode **106** in Step 506 includes forming a top electrode **106** from a material such as Al, Au, Ti, Ta, Pt, Cu, W, Ir, AlSi, or other noble metals.

Furthermore, in some aspects, applying an electrical field treatment to the CMR thin film **104** in Step 508 includes applying an electric field in the range of 0.4 to 1 megavolts per centimeter (MV/cm) with a pulse width in the range of **100** ns to 1 ms.

Furthermore, in some aspects, applying a bias voltage between the top electrode **106** and the bottom electrode **102** in Step 512 includes applying a bias voltage between the top electrode **106** and the bottom electrode **102** of either a dc voltage within the range of 0.5 to 5 volts, or a dc voltage within the range of -0.5 to -5 volts. Creating an inductance between the top electrode **106** and the bottom electrode **102** in Step 514 includes creating an inductance in the range of greater than 0.01 micro-Henry (µH) to less than 1 µH.

In some aspects, varying the inductance between the top and bottom electrodes in response to variances in the applied bias voltage in Step 518 includes creating the maximum inductance at a bias voltage of either approximately +1 dc volt, or approximately -1 dc volt.

As described above, an embodiment of the present invention includes: a step for forming a bottom electrode **102;** a step for forming a colossal magnetoresistance (CMR) thin film **104** overlying the bottom electrode **102;** a step for forming a top electrode **106** overlying the CMR thin film **104;** a step for applying an electrical field treatment in the range of 0.4 to 1 megavolts per centimeter (MV/cm) with a pulse width in the range of 100 ns to 1 ms to the CMR thin film **104**; a step for converting the CMR thin film **104** into a CMR thin film inductor in response to the electrical field treatment; a step for applying a bias voltage between the top electrode **106** and the bottom electrode **102;** and a step for creating an inductance between the top electrode **106** and the bottom electrode **102** in response to the applied bias voltage. When the applied bias voltage varies, the inductance varies in response to variances. Therefore, the size of the inductor can be reduced with a large inductance value. Furthermore, varying the inductance value in the IC circuit allows tuning to be performed more easily.

The inductor **100** according to the present invention has wider application than merely these examples. Likewise, a exemplary fabrication process has been given, but the solid-state inductor could be fabricated using equivalent processes and materials. Other variations and embodiments of the invention will occur to those skilled in the art.

As described above, according to the present invention, the size of the inductor can be reduced with a large inductance value. Furthermore, varying the inductance value in the IC circuit allows tuning to be performed more easily.

Various other modifications will be apparent to and can be readily made by those skilled in the art without departing from the scope and spirit of this invention. Accordingly, it is not intended that the scope of the claims appended hereto be limited to the description as set forth herein, but rather that the claims be broadly construed.

## Claims

1. A method for producing a solid-state inductor, the method comprising:
forming a bottom electrode;
forming a colossal magnetoresistance (CMR) thin film overlying the bottom electrode;
forming a top electrode overlying the CMR thin film; and
applying an electrical field treatment to the CMR thin film and, in response to the electrical field treatment, converting the CMR thin film into a CMR thin film inductor.

2. A method for producing a solid-state inductor according to claim 1, further comprising,
applying a bias voltage between the top and bottom electrodes, and, in response to the applied bias voltage, creating an inductance between the top and bottom electrodes.

3. A method for producing a solid-state inductor according to claim 2 further comprising:
varying the applied bias voltage; and
varying the inductance in response to variances in the applied bias voltage.

4. A method for producing a solid-state inductor according to claim 1 or 2, wherein forming a colossal magnetoresistance (CMR) thin film overlying the bottom electrode includes using a material selected from the group including Pr_{0.3}Ca_{0.7}MnO₃ (PCMO), La_{0.7}Ca_{0.3}MnO₃ (LCMO), Y₁₋ₓCaₓMnO₃ (YCMO), and high-temperature super conductor (HTSC) materials as a colossal magnetoresistance (CMR) thin film material.

5. A method for producing a solid-state inductor according to claim 1 or 2, wherein forming a colossal magnetoresistance (CMR) thin film overlying the bottom electrode includes forming a colossal magnetoresistance (CMR) thin film having a thickness of approximately 2000 Å.

6. A method for producing a solid-state inductor according to claim 1 or 4, wherein forming the colossal magnetoresistance (CMR) thin film overlying the bottom electrode includes:
spin-coating a first layer having a thickness of approximately 670 Å;
annealing the first layer at a temperature of approximately 650 degrees C for a period of approximately 30 minutes;
spin-coating a second layer, having a thickness of approximately 670 Å, overlying the first layer;
annealing the second layer at a temperature of approximately 550 degrees C for a period of approximately 30 minutes;
spin-coating a third layer, having a thickness of approximately 670 Å, overlying the second layer; and
annealing the third layer at a temperature of approximately 550 degrees C for a period of approximately 30 minutes.

7. A method for producing a solid-state inductor according to claim 2, wherein forming the bottom electrode includes forming the bottom electrode from a material selected from the group including Al, Au, Ti, Ta, Pt, Cu, W, Ir, AlSi, and other noble metals.

8. A method for producing a solid-state inductor according to claim 1 or 2, wherein forming the top electrode includes forming the top electrode from a material selected from the group including Al, Au, Ti, Ta, Pt, Cu, W, Ir, AlSi, and other noble metals.

9. A method for producing a solid-state inductor according to claim 1 or 2, wherein applying an electrical field treatment to the CMR thin film includes applying an electric field in the range of 0.4 to 1 megavolts per centimeter (MV/cm) with a pulse width in the range of 100 nanoseconds (ns) to 1 millisecond (ms).

10. A method for producing a solid-state inductor according to claim 3, wherein applying a bias voltage between the top and bottom electrodes includes applying a bias voltage selected from the group including:
a dc voltage within the range of 0.5 to 5 volts; and
a dc voltage within the range of -0.5 to -5 volts.

11. A method for producing a solid-state inductor according to claim 2, wherein creating an inductance between the top and bottom electrodes includes creating an inductance in the range of greater than 0.01 micro-Henry (µH) to less than 1 µH.

12. A method for producing a solid-state inductor according to claim 10, wherein varying the inductance between the top and bottom electrodes in response to variances in the applied bias voltage includes creating the maximum inductance at a bias voltage selected from the group including +1 dc volt and -1 dc volt.

13. A method for producing a solid-state inductor according to claim 1, wherein applying an electrical field treatment to the CMR thin film includes applying an electric field while simultaneously annealing the CMR thin film.

14. A method for producing a solid-state inductor, the method comprising:
forming a bottom electrode;
forming a colossal magnetoresistance (CMR) thin film overlying the bottom electrode;
forming a top electrode overlying the CMR thin film;
applying an electrical field treatment to the CMR thin film in the range of 0.4 to 1 megavolts per centimeter (MV/cm) with a pulse width in the range of 100 nanoseconds (ns) to 1 millisecond (ms) and, in response to the electrical field treatment, converting the CMR thin film into a CMR thin film inductor;
applying a bias voltage between the top and bottom electrodes;
in response to the applied bias voltage, creating an inductance between the top and bottom electrodes; and
varying the applied bias voltage and varying the inductance in response to varying the bias voltage.

15. A solid-state inductor, the inductor comprising:
a bottom electrode;
a colossal magnetoresistance (CMR) thin film overlying the bottom electrode; and
a top electrode overlying the electric field-treated CMR thin film.

16. A solid-state inductor according to claim 15 further comprising:
a means for applying a bias voltage between the top and bottom electrodes; and
wherein an inductance is created between the top and bottom electrodes in response to the applied bias voltage.

17. A solid-state inductor according to claim 16, wherein
the voltage applying means varies the applied bias voltage; and
the inductance between the top and bottom electrodes varies in response to variances in the applied bias voltage.

18. A solid-state inductor according to any one of claims 15-17, wherein the magnetoresistance (CMR) thin film includes a Pr_{0.3}Ca_{0.7}MnO₃ (PCMO), La_{0.7}Ca_{0.3}MnO₃ (LCMO), Y₁₋ₓCaₓMnO₃ (YCMO), and high-temperature super conductor (HTSC) materials.

19. A solid-state inductor according to claim 17, wherein the magnetoresistance (CMR) thin film has a thickness of approximately 2000 Å.

20. A solid-state inductor according to claim 15 or 16, wherein the bottom electrode includes a material selected from the group including Al, Au, Ti, Ta, Pt, Cu, W, Ir, AlSi, and other noble metals.

21. A solid-state inductor according to claim 15 or 16, wherein the top electrode is formed of a material selected from the group including Al, Au, Ti, Ta, Pt, Cu, W, Ir, AlSi, and other noble metals.

22. A solid-state inductor according to claim 15 or 16, wherein the electric field-treated CMR thin film has been exposed to an electric field in the range of 0. 4 to 1 MV/cm, with a pulse width in the range of 100 nanoseconds (ns) to 1 millisecond (ms).

23. A solid-state inductor according to claim 17, wherein the bias applying means applies a bias voltage between the top and bottom electrodes selected from the group including:
a dc voltage within the range of 0.5 to 5 volts; and
a dc voltage within the range of -0.5 to -5 volts.

24. A solid-state inductor according to claim 17, wherein the inductance between the top and bottom electrodes has a value in the range of greater than 0.01 micro-Henrys (µH) to less than 1 µH.

25. A solid-state inductor according to claim 23, wherein the inductance between the top and bottom electrodes is a maximum value in response to an applied bias voltage selected from the group including +1 dc volt and -1 dc volt.
